# EUROPEAN PATENT APPLICATION

(11) **EP 4 262 239 A1**
(43) Date of publication of application: **18.10.2023**
(21) Application number: 23167965.5
(22) Date of filing: 14.04.2023
(51) Int. Cl.: H04R 25/00

(54) **COMPACT ELECTRO-MECHANICAL PACKAGING FOR A CUSTOM HEARING DEVICE**

(30) Priority: 15.04.2022 US 202263331369 P
(71) Applicant: Starkey Laboratories, Inc., Eden Prairie, MN 55344 (US)
(72) Inventor: BORRA, Ganesh, Eden Prairie, 55344 (US); OWENS, Ryan, Eden Prairie, 55344 (US)
(74) Representative: Dentons UK and Middle East LLP

(57) **Abstract**

An ear-wearable electronic device (100) comprises a shell (102) having a uniquely-shaped outer surface that corresponds uniquely to an ear geometry of a wearer of the device (100). The shell (102) comprises a first contact surface (104). A battery housing (122) comprises a first mounting interface (121) and a battery compartment (126) configured to receive a battery (128). The battery housing (122) has a shape that conforms to that of the battery compartment (126). A faceplate (110) comprises a second mounting interface (106) configured to couple with the first mounting interface (121) of the battery housing (122), and a second contact surface (111) configured to matingly engage the first contact surface (104) of the shell (102). A flexible printed circuit board assembly (PCBA, 124) is supported by one or both of an exterior surface of the battery housing (122) and the faceplate (110).

## Description

### CROSS-REFERENCE TO RELATED APPLICATIONS

This application claims the benefit of U.S. Provisional Application No. 63/331,369 filed April 15, 2022, the content of which is incorporated herein by reference in its entirety.

### TECHNICAL FIELD

This application relates generally to hearing devices deployable at least partially in an ear canal, such devices including hearing aid, hearables, earbuds, and personal amplification devices.

### SUMMARY

Some embodiments are directed to an ear-wearable electronic device comprising a shell having a uniquely-shaped outer surface that corresponds uniquely to an ear geometry of a wearer of the device. The shell comprises a first contact surface. A battery housing comprises a first mounting interface and a battery compartment configured to receive a battery. The battery housing has a shape that conforms to that of the battery compartment. A faceplate comprises a second mounting interface configured to couple with the first mounting interface of the battery housing, and a second contact surface configured to matingly engage the first contact surface of the shell. A flexible printed circuit board assembly (PCBA) is supported by one or both of an exterior surface of the battery housing and the faceplate.

Some embodiments are directed to an ear-wearable electronic device comprising a shell having a uniquely-shaped outer surface that corresponds uniquely to an ear geometry of a wearer of the device. The shell comprises a first contact surface. A battery housing comprises a first mounting interface and a battery compartment configured to receive a battery. The battery housing has a shape that conforms to that of the battery compartment and comprising a short dimension and a long dimension. A faceplate comprises a second mounting interface configured to couple with the first mounting interface of the battery housing, a second contact surface configured to matingly engage the first contact surface of the shell, and an exterior surface orientated orthogonal to the long dimension of the battery compartment. A PCBA is supported by an exterior surface of the battery housing and a portion of the faceplate.

The above summary is not intended to describe each disclosed embodiment or every implementation of the present disclosure. The figures and the detailed description below more particularly exemplify illustrative embodiments.

### BRIEF DESCRIPTION OF THE DRAWINGS

Throughout the specification reference is made to the appended drawings wherein:
Figure 1 illustrates an ear-wearable electronic device in accordance with any of the embodiments disclosed herein;
Figure 2 is a side view of the ear-wearable electronic device shown in Figure 1;
Figure 3 illustrates various components of the ear-wearable electronic device shown in Figures 1 and 2;
Figure 4 illustrates various components of the ear-wearable electronic device shown in Figures 1 and 2;
Figure 5 is a view of a sub-assembly defined by a faceplate connected to a battery housing and a flexible PCBA in accordance with any of the embodiments disclosed herein;
Figure 6 is another view of a sub-assembly defined by a faceplate connected to a battery housing and a flexible PCBA in accordance with any of the embodiments disclosed herein;
Figure 7 is a further view of a sub-assembly defined by a faceplate connected to a battery housing and a flexible PCBA in accordance with any of the embodiments disclosed herein;
Figure 8 is another view of a sub-assembly defined by a faceplate connected to a battery housing and a flexible PCBA in accordance with any of the embodiments disclosed herein;
Figure 9 is an exploded view of the ear-wearable electronic device of Figures 1 and 2 showing various details of the fastening interfaces of the battery housing and faceplate of the device in accordance with any of the embodiments disclosed herein;
Figure 10 is a view of a sub-assembly defined by a faceplate connected to a battery housing and a flexible PCBA prior to installation in/on a custom shell in accordance with any of the embodiments disclosed herein;
Figure 11 is an exploded view of the ear-wearable electronic device of Figures 1 and 2 showing various details of the faceplate and battery housing of the device in accordance with any of the embodiments disclosed herein; and
Figure 12 is an exploded view of the ear-wearable electronic device of Figures 1 and 2 showing various details of the faceplate and battery housing of the device in accordance with any of the embodiments disclosed herein;
Figure 13 is a view of the ear-wearable electronic device of Figures 1 and 2 showing inclusion of a cross pin for securing components of the device in accordance with any of the embodiments disclosed herein;
Figure 14 is another view of the ear-wearable electronic device of Figures 1 and 2 showing inclusion of a cross pin for securing components of the device in accordance with any of the embodiments disclosed herein;
Figure 15 is a partial view of the ear-wearable electronic device of Figures 1 and 2 showing inclusion of a cross pin for securing the faceplate and battery housing of the device in accordance with any of the embodiments disclosed herein;
Figure 16 is another partial view of the ear-wearable electronic device of Figures 1 and 2 showing inclusion of a cross pin for securing the faceplate and battery housing of the device in accordance with any of the embodiments disclosed herein;
Figure 17 is a view of the ear-wearable electronic device of Figures 1 and 2 showing inclusion of a cross pin for securing components of the device in accordance with any of the embodiments disclosed herein; and
Figure 18 is a partial view of a battery housing of the ear-wearable electronic device of Figures 1 and 2 which supports a flexible antenna in accordance with any of the embodiments disclosed herein.

The figures are not necessarily to scale. Like numbers used in the figures refer to like components. However, it will be understood that the use of a number to refer to a component in a given figure is not intended to limit the component in another figure labeled with the same number.

### DETAILED DESCRIPTION

Custom in-the-ear hearing device manufacturing and assembly is time and process intensive. Increasing circuit sizes and added sensors require space-efficient and robust mechanical packaging. Current mechanical architecture of custom hearing aids design, especially for rechargeable hearing aids, poses several challenges.

For example, manufacturing process time is very high and also limits consistent device-to-device build. Various sensors (e.g., a MEMS sensor, such as an IMU) can potentially be exposed to their resonant frequency vibrations during manufacturing, which can negatively affect their functionality. Current faceplate material selected to allow for cutting and buffing does not allow for tighter/smaller features and therefore increases the overall size of the hearing device. Lithium-ion battery module sealing for patient safety adds additional size to the hearing device and assembly process time. Current mechanical architecture of custom hearing aids requires an additional structural spine to adequately secure a flexible printed circuit board, which adds additional size and complexity to the hearing device.

Embodiments disclosed herein are directed to electro-mechanical packaging approaches that can serve to modularize or standardize various features of a custom hearing device (e.g., a custom hearing aid) for ease of assembly, reduced packaging size, and increased quality. A modular or standard feature of a custom hearing device refers to any feature that has a predetermined configuration (e.g., shape, size, profile) which is common across a family or families of custom hearing devices. Among other configurations, a custom hearing device can be configured as an in-the-ear (ITE), in-the-canal (ITC), completely-in-canal (CIC) or invisible-in-canal (IIC) type hearing device.

According to various embodiments, a battery housing includes a mount that can be slid and/or snapped into a modular faceplate. The battery housing includes a battery compartment configured to receive a battery (e.g., a rechargeable battery). The battery housing can have a shape that conforms to the shape of the battery (e.g., a cylindrical shape). The battery compartment (with battery installed) can be sealed with a cap to enhance wearer safety.

A flexible PCBA is attached to the battery housing, such as by use of integrated attachment features and/or an adhesive. The flexible PCBA can include a portion that supports a sensor or other electronics, and this portion can be received by a slot in the faceplate. Because the battery housing supports the flexible PCBA, the hearing device need not include a spine which would otherwise be needed to support the flexible PCBA. Eliminating the need for a spine frees up volume within the shell, and allows for a reduction in the overall size of a custom hearing device.

The connected battery housing, faceplate, and flexible PCBA define a sub-assembly (e.g., an electro-mechanical package) which is pre-assembled prior to attachment to a custom shell. After connecting the battery housing to the faceplate and attaching the flexible PCBA to the battery housing, the sub-assembly is attached to a standardized contact surface of a custom shell, such as by use of an adhesive and/or a cross pin. This sub-assembly allows not only for a tighter and overall smaller design, but also more robust and secure design against mechanical vibrations and shocks during the life of the product.

The electro-mechanical packaging approach of the present disclosure eliminates significant post processing of faceplates and reduces assembly time, while also optimizing the space and robustly securing the overall electro-mechanical package. For example, the faceplate design can be standardized/modularized for all custom shells, thereby eliminating the conventional cutting and buffing steps for conventional faceplates. A matching profile to the faceplate can be created as part of custom printed ear shells which can be attached to the standard/modular faceplate.

As the faceplate material does not need to be cut or buffed, this can obviate the need for using conventional materials, such as a cellulosic thermoplastic. Tenite and other cellulosic thermoplastic materials, for example, may exhibit issues during the injection molding process of the faceplate which can result in higher wall thickness requirements, thereby increasing the overall size of the hearing device.

Depending on feature location, for example, this could lead to a wall thickness of at least 0.015" for tenite material, as higher pressures in the injection molding process would otherwise result in undesirable feature flash. According to a modular faceplate design of the present disclosure, stronger thermoplastic materials such as nylon, for example, can lead to a wall thickness as low as 0.008" for those same features. Use of stronger thermoplastic materials enables tighter and smaller features which serves to reduce the overall size of the custom hearing device. Reducing the size of a custom hearing aid, for example, is important in that the custom device needs to be small enough to fit into an ear without any protrusion while also being robust from a material strength standpoint.

Also, the thickness of the faceplate where it meets the shell can be optimized further by a factor of almost 3 times. Typically, with a cellulosic thermoplastic, the thickness is 0.075" for the section of faceplate where it meets the shell. With a modular faceplate according to the present disclosure, this thickness can reduce to 0.025" for the same section where it meets the shell. This thickness reduction represents a significant size advantage within the context of custom hearing devices for fit and comfort.

Moreover, injection molding the faceplate from a stronger thermoplastic like nylon and avoiding post-processing steps such as buffing and cutting of the faceplate offers the opportunity for paintable parts. This is not possible with conventional faceplate materials that need to be cut and buffed.

Another advantage of the disclosed modular faceplate is that the injection molding tool gate can be closer to all of the features. Whereas, with a custom molded faceplate, the gate is further away from the main features as there is excessive material left on each faceplate that must be post-processed out during the cutting and buffing process. Having the gate closer to all features allows for better quality, consistent fill, and less cosmetic issues during the injection molding process. This provides for tighter and closer packing of all design features with minimal wall thicknesses.

Embodiments of the disclosure are defined in the claims. However, below there is provided a non-exhaustive listing of non-limiting examples. Any one or more of the features of these examples may be combined with any one or more features of another example, embodiment, or aspect described herein.

Example Ex1. An ear-wearable electronic device comprises a shell having a uniquely-shaped outer surface that corresponds uniquely to an ear geometry of a wearer of the device, the shell comprising a first contact surface. A battery housing comprises a first mounting interface and a battery compartment configured to receive a battery, the battery housing having a shape that conforms to that of the battery compartment. A faceplate comprises a second mounting interface configured to couple with the first mounting interface of the battery housing, and a second contact surface configured to matingly engage the first contact surface of the shell. A flexible printed circuit board assembly (PCBA) is supported by one or both of an exterior surface of the battery housing and the faceplate.

Example Ex2. The device according to Ex1, wherein the battery compartment comprises an open side configured to receive the battery, and a cap is fixedly positioned at the open side to seal the battery within the battery compartment.

Example Ex3. The device according to Ex1 or Ex2, wherein the battery compartment has a cylindrical shape, and the battery housing has a shape that conforms to a curvature of the battery compartment.

Example Ex4. The device according to one or more of Ex1 to Ex3, wherein the battery compartment has a short dimension and a long dimension, and the faceplate comprises a substantially planar exterior surface oriented orthogonal to the long dimension of the battery compartment.

Example Ex5. The device according to one or more of Ex1 to Ex4, wherein the battery compartment has a cylindrical shape, and the flexible PCBA is attached to the exterior surface of the battery housing and conforms to the shape of the battery compartment.

Example Ex6. The device according to one or more of Ex1 to Ex5, wherein the battery has a cylindrical shape and comprises opposing flat sides, and a portion of the flexible PCBA extends across at least one of the opposing flat sides.

Example Ex7. The device according to one or more of Ex1 to Ex6, wherein the flexible PCBA comprises one or more arms that extend across, and attach to, the exterior surface of the battery housing.

Example Ex8. The device according to one or more of Ex1 to Ex7, wherein the flexible PCBA supports one or more sensors and one or more integrated circuits.

Example Ex9. The device according to one or more of Ex1 to Ex8, wherein the flexible PCBA supports an inertial measurement unit (IMU), and the IMU is positioned in an IMU slot of the faceplate.

Example Ex10. The device according to one or more of Ex1 to Ex9, wherein the faceplate comprises a pocket configured to receive a microphone, and the microphone is electrically connected to the flexible PCBA.

Example Ex11. The device according to one or more of Ex1 to Ex10, wherein the first mounting interface of the battery housing comprises a mount including a rail arrangement, and the second mounting interface of the faceplate comprises a channel arrangement configured to slidably receive the rail arrangement.

Example Ex12. The device according to one or more of Ex1 to Ex11, wherein the first and second mounting interfaces comprise a snap-fit attachment interface.

Example Ex13. The device according to one or more of Ex1 to Ex12, wherein the first and second mounting interfaces are maintained in a fastened state by a cross pin that passes through pin holes provided in a sidewall of the faceplate and pin holes provided in a mount of the battery housing.

Example Ex14. The device according to one or more of Ex1 to Ex13, wherein the first and second mounting interfaces, the faceplate, and the shell are maintained in a fastened state by a cross pin that passes through pin holes provided in a sidewall of the shell proximate the first contact surface, pin holes provided in a sidewall of the faceplate, and pin holes provided in a mount of the battery housing.

Example Ex15. The device according to one or more of Ex1 to Ex14, wherein the first and second mounting interfaces are maintained in a fastened state via an adhesive.

Example Ex16. The device according to one or more of Ex1 to Ex15, wherein a magnet is disposed between an interior surface of the faceplate and a mount of the battery housing.

Example Ex17. The device according to one or more of Ex1 to Ex16, wherein at least the battery housing and the faceplate comprise a nylon-based polyamide thermoplastic material.

Example Ex18. An ear-wearable electronic device comprises a shell having a uniquely-shaped outer surface that corresponds uniquely to an ear geometry of a wearer of the device, the shell comprising a first contact surface. A battery housing comprises a first mounting interface and a battery compartment configured to receive a battery, the battery housing having a shape that conforms to that of the battery compartment and comprising a short dimension and a long dimension. A faceplate comprises a second mounting interface configured to couple with the first mounting interface of the battery housing, a second contact surface configured to matingly engage the first contact surface of the shell, and an exterior surface orientated orthogonal to the long dimension of the battery compartment. A flexible printed circuit board assembly (PCBA) is supported by an exterior surface of the battery housing and a portion of the faceplate.

Example Ex19. The device according to Ex18, wherein the battery compartment comprises an open side configured to receive the battery, and a cap is fixedly positioned at the open side to seal the battery within the battery compartment.

Example Ex20. The device according to Ex18 or Ex19, wherein the battery compartment has a cylindrical shape, and the battery housing has a shape that conforms to a curvature of the battery compartment.

Example Ex21. The device according to one or more of Ex18 to Ex20, wherein the battery compartment has a cylindrical shape, and the flexible PCBA is attached to the exterior surface of the battery housing and conforms to the shape of the battery compartment.

Example Ex22. The device according to one or more of Ex18 to Ex21, wherein the battery has a cylindrical shape and comprises opposing flat sides, and a portion of the flexible PCBA extends across at least one of the opposing flat sides.

Example Ex23. The device according to one or more of Ex18 to Ex22, wherein the flexible PCBA comprises one or more arms that extend across, and attach to, the exterior surface of the battery housing.

Example Ex24. The device according to one or more of Ex18 to Ex23, wherein the flexible PCBA supports one or more sensors and one or more integrated circuits.

Example Ex25. The device according to one or more of Ex18 to Ex24, wherein the flexible PCBA supports an inertial measurement unit (IMU), and the IMU is positioned in an IMU slot in the faceplate.

Example Ex26. The device according to one or more of Ex18 to Ex25, wherein the faceplate comprises a pocket configured to receive a microphone, and the microphone is electrically connected to the flexible PCBA.

Example Ex27. The device according to one or more of Ex18 to Ex26, wherein the first mounting interface of the battery housing comprises a mount including a rail arrangement, and the second mounting interface of the faceplate comprises a channel arrangement configured to slidably receive the rail arrangement.

Example Ex28. The device according to one or more of Ex18 to Ex26, wherein the first and second mounting interfaces comprise a snap-fit attachment interface.

Example Ex29. The device according to one or more of Ex18 to Ex28, wherein the first and second mounting interfaces are maintained in a fastened state by a cross pin that passes through pin holes provided in a sidewall of the faceplate and pin holes provided in a mount of the battery housing.

Example Ex30. The device according to one or more of Ex18 to Ex28, wherein the first and second mounting interfaces, the faceplate, and the shell are maintained in a fastened state by a cross pin that passes through pin holes provided in a sidewall of the shell proximate the first contact surface, pin holes provided in a sidewall of the faceplate, and pin holes provided in a mount of the battery housing.

Example Ex31. The device according to one or more of Ex18 to Ex30, wherein the first and second mounting interfaces are maintained in a fastened state via an adhesive.

Example Ex32. The device according to one or more of Ex18 to Ex30, wherein a magnet is disposed between an interior surface of the faceplate and a mount of the battery housing.

Example Ex33. The device according to one or more of Ex18 to Ex32, wherein at least the battery housing and the faceplate comprise a nylon-based polyamide thermoplastic material.

Example Ex34. The device according to one or more of Ex1 to Ex33, wherein a flexible antenna is disposed on an outer surface of the battery housing or a closed end of the battery compartment.

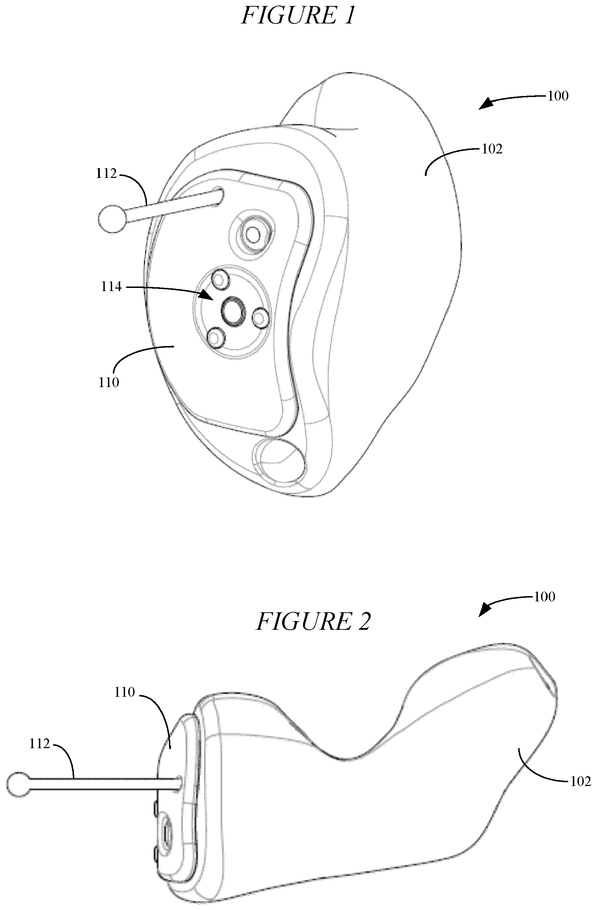

Figures 1 and 2 illustrate an ear-wearable electronic device 100 in accordance with any of the embodiments disclosed herein. The device 100 can represent a variety of different custom hearing devices, and can be configured as an in-the-ear (ITE), in-the-canal (ITC), completely-in-canal (CIC) or invisible-in-canal (IIC) type hearing device, for example. The device 100 includes a shell 102 having a uniquely shaped outer surface that corresponds uniquely to the ear geometry of a wearer of the device 100. For example, the shell 102 can be developed based on a mold taken from a wearer's ear. As such, the device 100 can be considered a custom ear-wearable electronic device which is shaped to conform to the unique ear geometry of a particular wearer of the device 100.

The device 100 also includes a faceplate 110 which is shown connected to the shell 102. The faceplate 110 can include a number of features, such as charge contacts 114 and a removal handle 112. The charge contacts 114 are configured to engage charge contacts of a charging unit when charging a battery of the device 100. In some implementations, the faceplate 110 can be connected to the shell 102 using an adhesive. In other implementations, and as discussed in detail below, the faceplate 110 can be connected to the shell 102 using a cross pin, alone or with use of an adhesive.

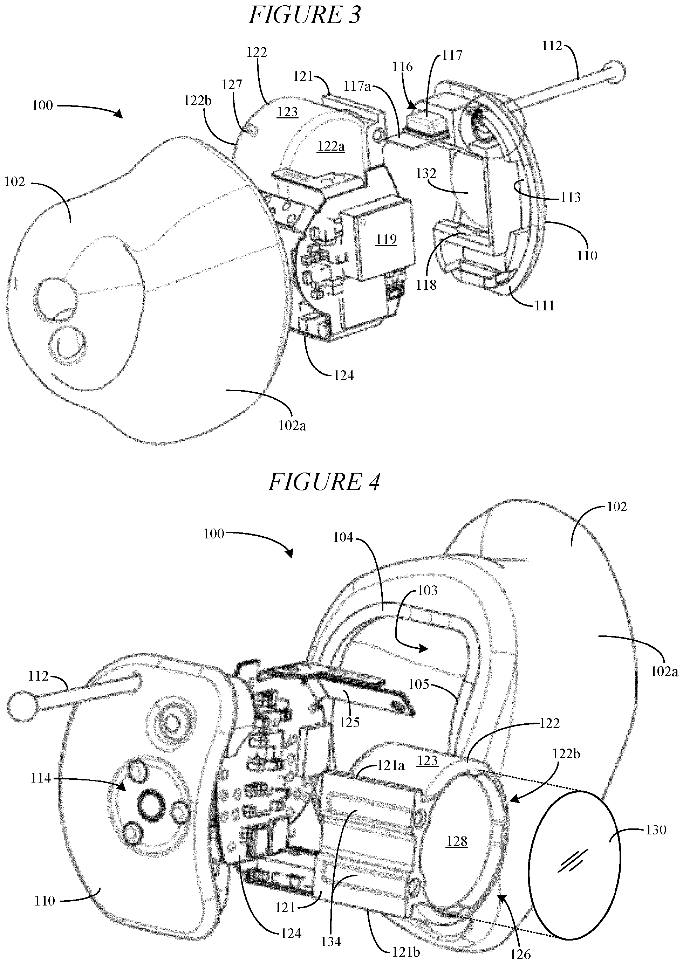

With reference to Figures 3 and 4, the shell 102 includes a first contact surface 104 having a predefined configuration which can be standardized across a family or families of devices 100. The shell 102 includes a shell body 102a, a void 103 within the shell body 102a, and an opening 105 to the void 103. The first contact surface 104 defines a substantially flat portion of the shell 102 disposed along the portion of the shell body 102a that forms the opening 105 to the void 103.

The faceplate 110 has an interior surface 113 which includes a second contact surface 111 having a predefined configuration which can be standardized across the same family or families of the devices 100. The second contact surface 111 extends along a periphery of the interior surface 113 of the faceplate 110 and has a generally flat shape. More particularly, the second contact surface 111 of the faceplate 110 has a shape and size configured to matingly engage the first contact surface 104 of the shell 102. Standardization of the first contact surface 104 of the shell 102 and the second contact surface 111 of the faceplate 110 significantly reduces the manufacturing complexity and cost of fabricating a custom ear-wearable electronic device, while providing for a custom-shaped shell 102 unique to the ear geometry of a particular wearer of the device 100.

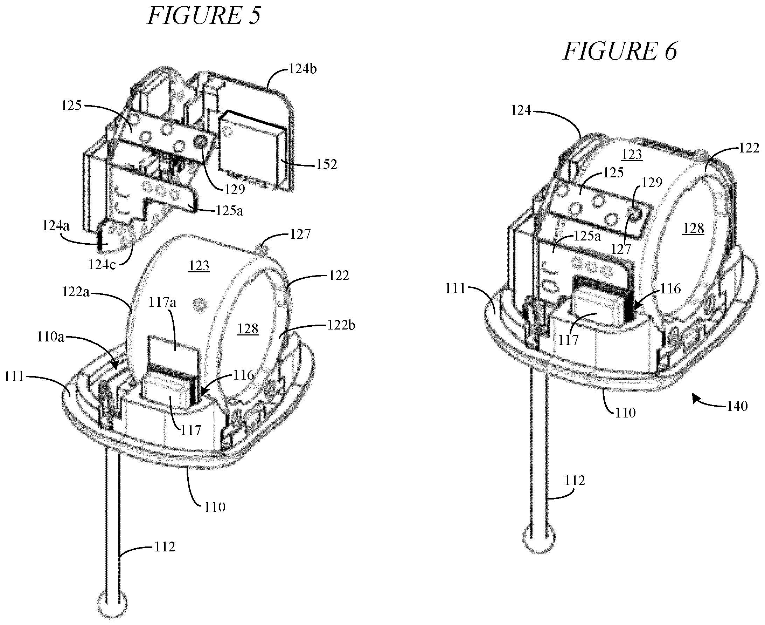

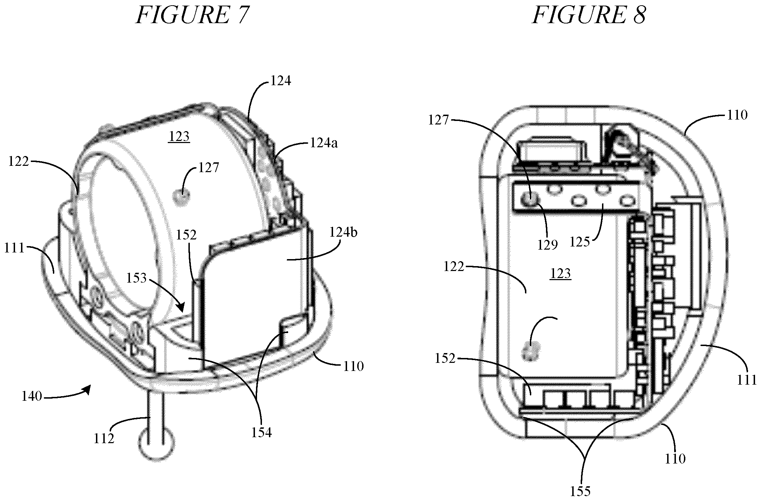

Figures 3 and 4 show other components of the device 100 including a battery housing 122 and a flexible PCBA 124. Details of these components discussed below are further shown in Figures 5-10. The battery housing 122 includes a battery compartment 126 (see, e.g., Figure 4) configured to receive a rechargeable battery 128, such as a lithium-ion battery. As shown, the battery compartment 126 and battery housing 122 have a shape that conforms to the shape of the battery 128. More particularly, the battery 128, battery housing 122, and battery compartment 126 are shown to have a generally cylindrical shape. It is noted that, in some implementations, the battery 128 can have a polygonal shape (e.g., rectangle, square), and that the battery housing 122 and battery compartment 126 can conform to the shape of the polygonal battery 128. However, a cylindrical battery 128, battery housing 122, and battery compartment 126 are preferred for enhancing packaging efficiency. The battery housing 122 and battery compartment 126 can be formed from plastic.

As is shown in Figures 3 and 4, the battery compartment 126 includes a closed end 122a and an opposing open end 122b. The open end 122b is dimensioned to receive the battery 128. The open end 122b can be configured to receive a cap 130 in order to seal the battery 128 within the battery compartment 126 for purposes of safety. The cap 130 can be snapped into place to seal the battery 128 within the battery compartment 126. Alternatively, or in addition, the cap 130 can be held in place by a suitable adhesive.

In some implementations, the battery compartment 126 has a short dimension and a long dimension depending on the shape of the battery 128. In such implementations, the faceplate 110, which has a generally flat and curved exterior surface, is preferably oriented orthogonal to the long dimension of the battery compartment 126. For example, the battery 128 can have a cylindrical shape with two opposing flat sides. The battery compartment 126 can be configured such that the flat sides of the battery 128 are oriented orthogonal to the exterior surface of the faceplate 110. This orientation of the battery 128 relative to the faceplate 110 provides for a tighter and smaller packaging fit for the battery 128 and battery housing 122.

With continued reference to Figures 3-8, the battery housing 122 includes an exterior surface 123 to which the flexible PCBA 124 can be attached. It is understood that the flexible PCBA 124 is a laminated, flexible sandwich structure comprising conductive layers, insulating layers, and vias allowing for interconnections between layers. The flexible PCBA 124 can support and/or be coupled to various electronic components (e.g., integrated circuits, processors, memories), electrical circuitry (passive and active electrical components), one or more sensors (e.g., IMU 152), and/or one or more transducers (e.g., microphone 117, receiver 119).

Referring in particular to Figures 5-8, the flexible PCBA 124 has a first surface 124a which is configured to face the closed end 122a of the battery housing 122. The first surface 124a of the flexible PCBA 124 can cover some or all of the closed end 122a of the battery housing 122. The flexible PCBA 124 can include a second surface 124b which is configured to face the exterior surface 123 (e.g., curved surface) of the battery housing 122.

As shown, the second surface 124b of the flexible PCBA 124 wraps around the battery housing 122 such that the second surface 124b is substantially orthogonal to the first surface 124a of the flexible PCBA 124. The second surface 124b of the flexible PCBA 124 can be configured to support an IMU 152. In some implementations, the flexible PCBA 124 can include a third surface which can connect to the second surface 124b (or the first surface 124a) and be arranged to face the open or capped end 122b of the battery housing 122.

As discussed above, the second surface 124b of the flexible PCBA 124 can support an IMU 152. The faceplate 110 includes an IMU slot 153 dimensioned to receive the IMU 152. IMU retention features 154 and retentions edges 155 are provided in the faceplate 110 and facilitate secured positioning of the IMU 152 in the IMU slot 153.

Positioning the IMU 152 in the IMU slot 153 serves to secure the second surface 124b of the flexible PCBA 124 in the faceplate 110, thereby preventing the second surface 124b from flopping about. The IMU 152 can be representative of an integrated inertial measurement unit, one or more accelerometers (e.g., a 3-axis accelerometer), or one or more gyros (e.g., a 3-axis gyro).

In some embodiments, the flexible PCBA 124 includes one or more arms 125 that extend outwardly from the first surface 124a of the flexible PCBA 124 and over the exterior surface 123 of the battery housing 122. Although not shown, one or more arms 125 can extend outwardly from the second surface 124b of the flexible PCBA 124 and over the exterior surface 123 of the battery housing 122. Some or all of the arms 125 can include at least one fastening hole 129. It is noted that some of the arms 125 can be devoid of electrical/electronic circuitry and serve as attachment arms. Some of the arms 125 can support electrical and/or electronic circuitry while concurrently serving as attachment arms.

The exterior surface 123 of the battery housing 122 can include a number of fastening posts 127. As best shown in Figures 5-8, the battery housing 122 and PCBA 124 are brought together during assembly so that the arms 125 of the flexible PCBA 124 extend over the exterior surface 123 of the battery housing 122. The fastening holes 129 of the arms 125 are aligned with the fastening posts 127 on the exterior surface 123 such that the fastening posts 127 pass through the fastening holes 129 to attach the flexible PCBA 124 to the battery housing 122. It is noted that other attachment mechanisms can be used to attach the flexible PCBA 124 to the battery housing 122, such as an adhesive or snap-fit features. As was discussed previously, attaching the flexible PCBA 124 to the battery housing 122 effectively utilizes the battery housing 122 as a spine for supporting the flexible PCBA 124, thereby obviating the need for an additional spine structure.

As is shown in Figures 5 and 6, a microphone 117 is positioned within a microphone pocket 116 of the faceplate 110. An arm 125a of the flexible PCBA 124 extends over the exterior surface 123 of the battery housing 122 and electrically connects with a microphone circuit 117a attached to the microphone 117. In some implementations, the microphone circuit 117a can be soldered to electrical connections of the arm 125a of the flexible PCBA 124. In other implementations, separate electrical conductors can connect (e.g., via solder joints) the microphone circuit 117a and electrical connectors of the arm 125a or the first surface 124a of the flexible PCBA 124.

During the device assembly process, the battery housing 122 can be attached to the faceplate 110 in a manner described in detail hereinbelow. With the battery housing 122 attached to the faceplate 110 (see Figure 5), the flexible PCBA 124 is attached to the battery housing 122 (see Figures 6-8). Attaching the flexible PCBA 124 to the battery housing 122 involves positioning an edge 124c of the first surface 124a of the flexible PCBA 124 within a groove 110a of the faceplate 110 defined between the closed end 122a of the battery compartment 126 and the second contact surface 111 of the faceplate 110. As the first surface 124a of the flexible PCBA 124 is seated within the groove 110a, the IMU 152 disposed on the second surface 124b of the flexible PCBA 124 is also seated within the IMU slot 153 in the faceplate 110. The flexible PCBA 124 is secured to the exterior surface 123 of the battery housing 122 via the post and hole arrangement 127/129 and stabilized by the IMU 152 positioned within the IMU slot 153.

It is noted that, in some embodiments, the flexible PCBA 124 is supported by both of the exterior surface 123 of the battery housing 122 and the faceplate 110 (e.g., via the IMU slot 153 or other structure). In other embodiments, the flexible PCBA 124 is supported by the exterior surface 123 of the battery housing 122, but not by the faceplate 110. In further embodiments, such as in the case of a relatively simple or small implementation, the flexible PCBA 124 is supported by the faceplate 110 (e.g., via the IMU slot 152 or other structure), but not by the battery housing 122.

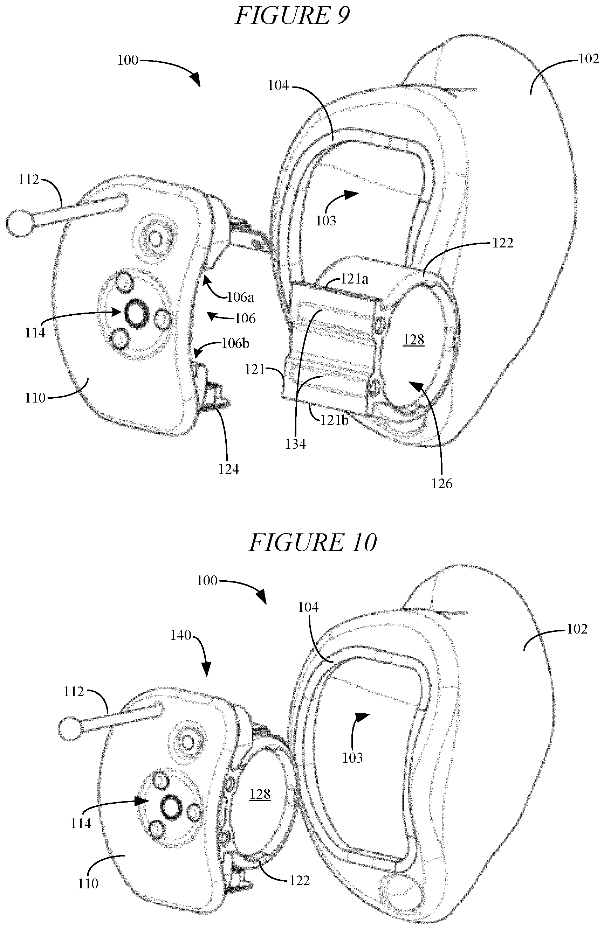

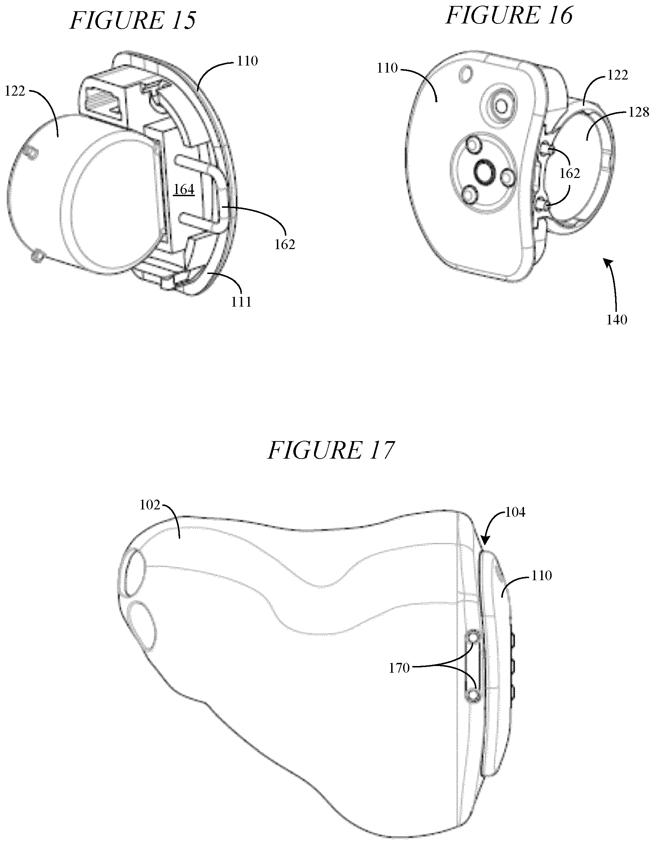

The connected battery housing 122, flexible PCBA 124, and faceplate 110 define a sub-assembly 140 which is assembled prior to attachment to the shell 102 as discussed above. After assembly, the sub-assembly 140 is manipulated to position the sub-assembly 140 within the void 103 of the shell 102. The sub-assembly 140 can then be attached to the custom shell 102 (see Figure 10). In some implementations, the second contact surface 111 of the faceplate 110 is glued to the first contact surface 104 of the shell 102 using a suitable adhesive. In other implementations, and as shown in Figure 16 discussed below, the second contact surface 111 of the faceplate 110 is secured to the first contact surface 104 of the shell 102 using a cross pin that passes through the shell 102 and the sub-assembly 140.

Referring now to Figure 9 (and with continued reference to Figures 3 and 4), the battery housing 122 includes a first fastening interface configured to connect to a second fastening interface of the faceplate 110. As illustrated, the first fastening interface of the battery housing 122 comprises a mount 121 which includes a first rail 121a and a second rail 121b. The second fastening interface of the faceplate 110 comprises a channel arrangement 106 which includes a first channel 106a and a second channel 106b. The first channel 106a is configured to receive the first rail 121a, and the second channel 106b is configured to receive the second rail 121b.

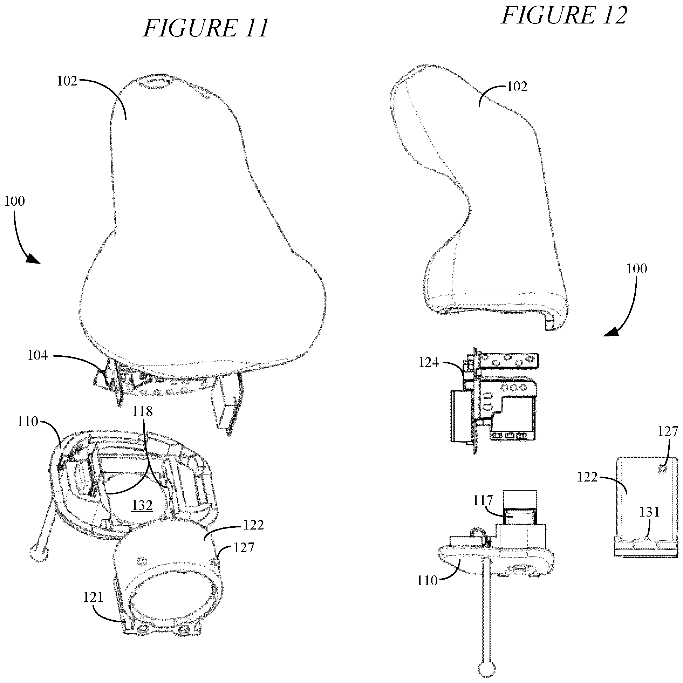

In this arrangement, the mount 121 of the battery housing 122 can be slidably attached to the channel arrangement 106 of the faceplate 110, with the first and second rails 121a, 121b being captured within the first and second channels 106a, 106b. In some implementations, the channel arrangement 106 and the mount 121 can include snap-fit features 118 (see e.g., Figures 3, 11), 131 (see e.g., Figure 12) which facilitate a snap-fit between the battery housing 122 and the faceplate 110.

As best seen in Figures 3 and 11, a magnet 132 is positioned between an interior surface of the faceplate 110 and the mount 121 of the battery housing 122. The magnet 132 is positioned on the interior surface 113 of the faceplate 110 in close proximity to the charge contacts 114 disposed on the opposing surface of the faceplate 110. The magnet 132 is configured to magnetically secure the device 100 to a charging unit (e.g., a portable charging case comprising a corresponding magnet or magnetizable material) such that the charge contacts 114 matingly engage charge contacts of the charging unit when charging the battery 128 of the device 100. As shown in Figures 4 and 9, the mount 121 of the battery housing 122 can include retention ribs 134 configured to press the magnet 132 in place when the mount 121 is positioned on the faceplate 110. It is noted that, in some implementations, the battery 128 can be charged by induction charging circuitry, which obviates the need for the charge contacts 114 and the magnet 132. In some implementations that include the charge contacts 114, the magnet 132 can be excluded, and a nesting mechanism can be included to appropriately position the charge contacts 114 relative to charge contacts of the charging unit.

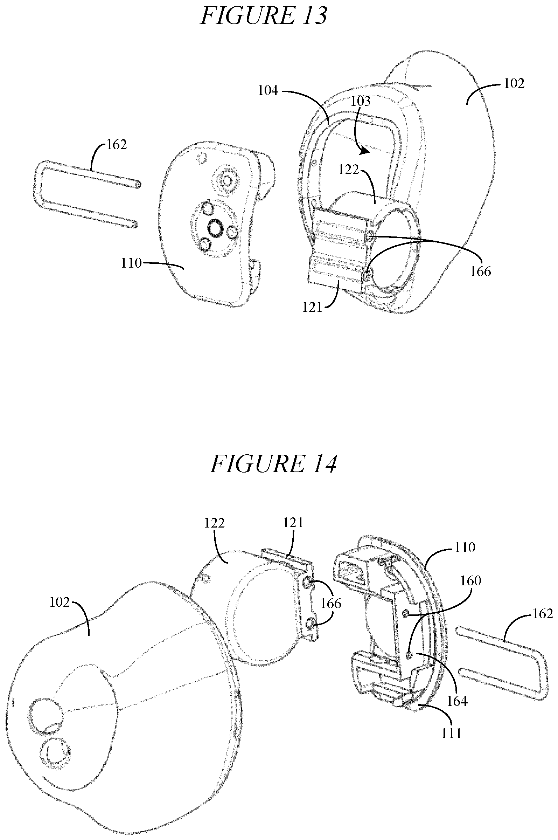

As was previously discussed, and with reference to Figures 13-17, the battery housing 122 can be secured to the faceplate 110 using a cross pin 162. The flexible PCBA 124 is not shown in Figures 13-17 so that the cross pin features are more readily seen. In such implementations, the faceplate 110 includes cross pin holes 160 provided in a sidewall 164 of the faceplate 110 (see Figure 14). The mount 121 of the battery housing 122 includes corresponding cross pin holes 166 that pass through the mount 121 (see Figure 13).

With the battery housing 122 attached to the faceplate 110, such as shown in Figure 15, the cross pin 162 can be pushed through the respective cross pin holes 160, 166. Figure 16 shows the cross pin 162 fully inserted into the respective cross pin holes 160, 166, which secures the battery housing 122 (with the flexible PCBA 124 attached thereto) to the faceplate 110. It is understood that the cross pin arrangement shown in Figure 13-17 can be used as the primary or sole feature for securing the battery housing 122 to the faceplate 110, but can be supplemented by use of snap-fit features 118, 131 and/or an adhesive.

In some implementations, and as shown in Figure 17, the shell 102 can include cross pin holes 170 provided through opposing side surfaces of the shell 102 at or proximate the first contact surface 104. The cross pin holes 170 can be provided in a wall section of the shell 102 at or proximate the first contact surface 104. With the sub-assembly 140 (battery housing 122, flexible PCBA 124, faceplate 110) positioned within the void 103 of the shell 102, and with the first contact surface 104 of the shell 102 in contact with the second contact surface 111 of the faceplate 110, the cross pin 162 can be inserted into and thorough respective cross pin holes 160, 166, and 170. The cross pin implementation shown in Figure 17 provides for secured connection of the sub-assembly 140 and the shell 102.

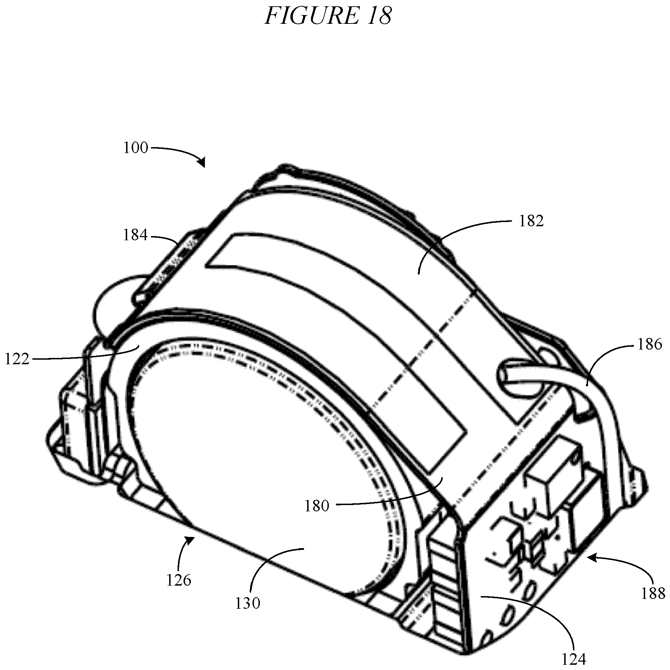

Figure 18 illustrates an ear-wearable electronic device 100 in accordance with any of the embodiments disclosed herein. The device 100 shown in Figure 18 includes a flexible antenna 180 disposed over an outer surface of the battery housing 122. In the embodiment shown in Figure 18, the flexible antenna 180 is part of (e.g., an extension of) the flexible PCBA 124. In this configuration, traces extend from radio components 188 supported by the flexible PCBA 124 to an internal antenna structure 182 within the flexible antenna 180. As shown, the flexible antenna 180 conforms to the shape of the outer surface (e.g., curved surface) of the battery housing 122.

The flexible antenna 180 is held in place on the battery housing 122 by a hold-down feature 184. The hold-down feature 184 is attached to the battery housing 122 and connects to an end of the flexible antenna 180. The hold-down feature 184 serves to secure the flexible antenna 180 to the battery housing 122. Other attachment mechanisms are contemplated for securing the flexible antenna 180 to the battery housing 122 alone or in combination with the hold-down feature 184, such as snap-fit features and/or an adhesive.

According to some embodiments, the antenna structure of the device 100 can include the flexible antenna 180 and an antenna 186 disposed in a removal handle of the device 100 (see, e.g., removal handle 112 shown in Figures 1-7). The removal handle antenna 186 can comprise a number of wires wrapped around a fiber material, with the wires and fiber material being contained in an elastomeric material. The wires of the removal handle antenna 186 can be soldered to the internal antenna structure 182, as is shown in Figure 18. In this configuration, the flexible antenna 180 and the removal handle antenna define a single antenna of the device 100, which can be configured as a monopole antenna.

In some embodiments, the flexible antenna 180 is a structure separate from, but coupled to, the PCBA 124. In some embodiments, the flexible antenna 180 can be disposed on the closed end 130 of the battery compartment 126. In other embodiments, the flexible antenna 180 can be disposed on the outer surface of the battery housing 122 and the closed end 130 of the battery compartment.

It is understood that various embodiments described herein may be implemented with any custom ear-wearable electronic device without departing from the scope of this disclosure. The devices depicted in the figures are intended to demonstrate the subject matter, but not in a limited, exhaustive, or exclusive sense. Ear-wearable electronic devices, such as hearables (e.g., personal amplification devices, earbuds), hearing aids, and hearing assistance devices, include a custom shell within which internal components are disposed. Typical components of an ear-wearable electronic device can include a digital signal processor (DSP), a controller, other digital logic circuitry (e.g., ASICs, FPGAs), memory (e.g., ROM, RAM, SDRAM, NVRAM, EEPROM, and FLASH), power management circuitry (e.g., including charging circuitry), one or more communication devices (e.g., an RF radio, a near-field magnetic induction (NFMI) device), one or more antennas, one or more microphones, audio processing circuitry, and an acoustic transducer (e.g., receiver/speaker), for example. Some ear-wearable electronic devices can incorporate a long-range communication device, such as a Bluetooth^{®} transceiver or other type of radio frequency (RF) transceiver. A communication device (e.g., a radio or NFMI device) of an ear-wearable electronic device can be configured to facilitate communication between a left ear device and a right ear device. These and other components can be supported by, or coupled to, the flexible PCBA of the device as previously discussed.

Some ear-wearable electronic devices can incorporate one or more sensors in addition to an IMU. For example, an ear-wearable electronic device can incorporate one or more of a temperature sensor, an optical PPG sensor (e.g., pulse oximeter), a physiologic electrode-based sensor (e.g., ECG, oxygen saturation (SpO2), respiration, EMG, EEG, EOG, galvanic skin response, electrodermal activity sensor), and a biochemical sensor (e.g., glucose concentration, PH value, Ca+ concentration, hydration). Embodiments disclosed herein can incorporate one or more of the sensors disclosed in commonly-owned co-pending U.S. Patent Application Serial Nos. 63/125,700 filed December 15, 2020 under Attorney Docket No. ST0822PRV/0532.000822US60 and 63/126,426 filed December 16, 2020 under Attorney Docket No. ST0831PRV/0532.000831US60, both of which are incorporated herein by reference in their entireties.

The term ear-wearable electronic device of the present disclosure refers to a wide variety of ear-wearable electronic devices that can aid a person with impaired hearing. The term ear-wearable electronic device also refers to a wide variety of devices that can produce optimized, amplified or processed sound for persons with normal hearing. Ear-wearable electronic devices of the present disclosure include hearables (e.g., earbuds) and hearing aids (e.g., hearing instruments), for example. As previously discussed, ear-wearable electronic devices include, but are not limited to, ITE, ITC, CIC or IIC type hearing devices.

Although reference is made herein to the accompanying set of drawings that form part of this disclosure, one of at least ordinary skill in the art will appreciate that various adaptations and modifications of the embodiments described herein are within, or do not depart from, the scope of this disclosure. For example, aspects of the embodiments described herein may be combined in a variety of ways with each other. Therefore, it is to be understood that, within the scope of the appended claims, the claimed invention may be practiced other than as explicitly described herein.

All references and publications cited herein are expressly incorporated herein by reference in their entirety into this disclosure, except to the extent they may directly contradict this disclosure. Unless otherwise indicated, all numbers expressing feature sizes, amounts, and physical properties used in the specification and claims may be understood as being modified either by the term "exactly" or "about." Accordingly, unless indicated to the contrary, the numerical parameters set forth in the foregoing specification and attached claims are approximations that can vary depending upon the desired properties sought to be obtained by those skilled in the art utilizing the teachings disclosed herein or, for example, within typical ranges of experimental error.

The recitation of numerical ranges by endpoints includes all numbers subsumed within that range (e.g. 1 to 5 includes 1, 1.5, 2, 2.75, 3, 3.80, 4, and 5) and any range within that range. Herein, the terms "up to" or "no greater than" a number (e.g., up to 50) includes the number (e.g., 50), and the term "no less than" a number (e.g., no less than 5) includes the number (e.g., 5).

The terms "coupled" or "connected" refer to elements being attached to each other either directly (in direct contact with each other) or indirectly (having one or more elements between and attaching the two elements). Either term may be modified by "operatively" and "operably," which may be used interchangeably, to describe that the coupling or connection is configured to allow the components to interact to carry out at least some functionality (for example, a radio chip may be operably coupled to an antenna element to provide a radio frequency electric signal for wireless communication).

Terms related to orientation, such as "top," "bottom," "side," and "end," are used to describe relative positions of components and are not meant to limit the orientation of the embodiments contemplated. For example, an embodiment described as having a "top" and "bottom" also encompasses embodiments thereof rotated in various directions unless the content clearly dictates otherwise.

Reference to "one embodiment," "an embodiment," "certain embodiments," or "some embodiments," etc., means that a particular feature, configuration, composition, or characteristic described in connection with the embodiment is included in at least one embodiment of the disclosure. Thus, the appearances of such phrases in various places throughout are not necessarily referring to the same embodiment of the disclosure. Furthermore, the particular features, configurations, compositions, or characteristics may be combined in any suitable manner in one or more embodiments.

The words "preferred" and "preferably" refer to embodiments of the disclosure that may afford certain benefits, under certain circumstances. However, other embodiments may also be preferred, under the same or other circumstances. Furthermore, the recitation of one or more preferred embodiments does not imply that other embodiments are not useful and is not intended to exclude other embodiments from the scope of the disclosure.

As used in this specification and the appended claims, the singular forms "a," "an," and "the" encompass embodiments having plural referents, unless the content clearly dictates otherwise. As used in this specification and the appended claims, the term "or" is generally employed in its sense including "and/or" unless the content clearly dictates otherwise.

As used herein, "have," "having," "include," "including," "comprise," "comprising" or the like are used in their open-ended sense, and generally mean "including, but not limited to." The term "and/or" means one or all of the listed elements or a combination of at least two of the listed elements.

The phrases "at least one of," "comprises at least one of," and "one or more of" followed by a list refers to any one of the items in the list and any combination of two or more items in the list.

## Claims

1. An ear-wearable electronic device, comprising:
a shell having a uniquely-shaped outer surface that corresponds uniquely to an ear geometry of a wearer of the device, the shell comprising a first contact surface;
a battery housing comprising a first mounting interface and a battery compartment configured to receive a battery, the battery housing having a shape that conforms to that of the battery compartment;
a faceplate comprising:
a second mounting interface configured to couple with the first mounting interface of the battery housing; and
a second contact surface configured to matingly engage the first contact surface of the shell; and
a flexible printed circuit board assembly (PCBA) supported by one or both of an exterior surface of the battery housing and the faceplate.

2. The device of claim 1, wherein:
the battery compartment comprises an open end configured to receive the battery; and
a cap is fixedly positioned at the open end to seal the battery within the battery compartment.

3. The device of claim 1 or claim 2, wherein:
the battery compartment has a cylindrical shape; and
the battery housing has a shape that conforms to a curvature of the battery compartment and/or the flexible PCBA is attached to the exterior surface of the battery housing and conforms to the shape of the battery compartment.

4. The device of claim 4, wherein:
the battery comprises opposing flat sides; and
a portion of the flexible PCBA extends across at least one of the opposing flat sides.

5. The device of any preceding claim, wherein:
the battery compartment has a short dimension and a long dimension; and
the faceplate comprises a substantially planar exterior surface oriented orthogonal to the long dimension of the battery compartment.

6. The device of any preceding claim, wherein:
the first mounting interface of the battery housing comprises a mount including a rail arrangement; and
the second mounting interface of the faceplate comprises a channel arrangement configured to slidably receive the rail arrangement.

7. The device of any preceding claim, wherein the first and second mounting interfaces comprise a snap-fit attachment interface, wherein the first and second mounting interfaces are maintained in a fastened state by a cross pin that passes through pin holes provided in a sidewall of the faceplate and pin holes provided in a mount of the battery housing, and/or wherein the first and second mounting interfaces are maintained in a fastened state via an adhesive.

8. The device of any preceding claim, further comprising a magnet disposed between an interior surface of the faceplate and a mount of the battery housingand/or a flexible antenna disposed on an outer surface of the battery housing or a closed end of the battery compartment.

9. An ear-wearable electronic device, comprising:
a shell having a uniquely-shaped outer surface that corresponds uniquely to an ear geometry of a wearer of the device, the shell comprising a first contact surface;
a battery housing comprising a first mounting interface and a battery compartment configured to receive a battery, the battery housing having a shape that conforms to that of the battery compartment and comprising a short dimension and a long dimension;
a faceplate comprising:
a second mounting interface configured to couple with the first mounting interface of the battery housing;
a second contact surface configured to matingly engage the first contact surface of the shell; and
an exterior surface orientated orthogonal to the long dimension of the battery compartment; and
a flexible printed circuit board assembly (PCBA) supported by an exterior surface of the battery housing and a portion of the faceplate.

10. The device of claim 9, wherein:
the battery compartment comprises an open end configured to receive the battery; and
a cap is fixedly positioned at the open end to seal the battery within the battery compartment, and/or wherein:
the battery compartment has a cylindrical shape; and
the battery housing has a shape that conforms to a curvature of the battery compartment.

11. The device of claim 9 or claim 10, wherein:
the battery compartment has a cylindrical shape; and
the flexible PCBA is attached to the exterior surface of the battery housing and conforms to the shape of the battery compartment, and optionally wherein:
the battery comprises opposing flat sides; and
a portion of the flexible PCBA extends across at least one of the opposing flat sides.

12. The device of any of claims 9 to 11, wherein:
the first mounting interface of the battery housing comprises a mount including a rail arrangement; and
the second mounting interface of the faceplate comprises a channel arrangement configured to slidably receive the rail arrangement.

13. The device of any of claims 9 to 12, wherein the first and second mounting interfaces comprise a snap-fit attachment interface, wherein the first and second mounting interfaces are maintained in a fastened state by a cross pin that passes through pin holes provided in a sidewall of the faceplate and pin holes provided in a mount of the battery housing, and/or wherein the first and second mounting interfaces are maintained in a fastened state via an adhesive.

14. The device of any of claims 9 to 13, further comprising a magnet disposed between an interior surface of the faceplate and a mount of the battery housing and/or a flexible antenna disposed on an outer surface of the battery housing or a closed end of the battery compartment.

15. The device of according to any of claims 9 to 14, wherein at least the battery housing and the faceplate comprise a nylon-based polyamide thermoplastic material, and/or wherein the flexible PCBA supports one or more sensors and one or more integrated circuits.
